# EUROPÄISCHE PATENTSCHRIFT

(11) **EP 0 823 764 B1**
(45) Veröffentlichungstag und Bekanntmachung des Hinweises auf die Patenterteilung: **13.12.2000**
(21) Anmeldenummer: 97111685.0
(22) Anmeldetag: 10.07.1997
(51) Int. Cl.: H02H 3/33, G01R 31/333

(54) **Verfahren zur Funktionsprüfung und Ermittlung des Auslösestroms von gleichstrom- oder allstromsensitiven Fehlerstromschutzschaltern**
Process for checking the operation, and determining the trip current, of residual current breakers responsive to DC or any current
Procédé pour la vérification du fonctionnement, et pour la détermination du courant de déclenchement, des disjoncteurs sensibles à tout courant de défaut

(30) Priorität: 05.08.1996 DE 19631611
(43) Veröffentlichungstag der Anmeldung: 11.02.1998
(73) Patentinhaber: GOSSEN-METRAWATT Gesellschaft mit beschränkter Haftung, D-90471 Nürnberg (DE)
(72) Erfinder: Schweiger, Raimund, Dr.-Ing., 92280 Kastl (DE)
(74) Vertreter: Hafner, Dieter, Dr.rer.nat., Dipl.-Phys.

(56) Entgegenhaltungen:
- EP-A- 0 368 030

## Beschreibung

Die Erfindung betrifft ein Verfahren zur Funktionsprüfung und Ermittlung des Auslösestroms von gleichstrom- oder allstromsensitiven Fehlerstromschutzschaltern.

### Stand der Technik:

Gleichstrom- oder allstromsensitive Fehlerstromschutzschalter sind erst seit kurzer Zeit in Europa verfügbar und für den Einsatz in Netzen zugelassen. Derzeit wird ein Verfahren zur Prüfung dieser Schalterart angewandt, das sich wie folgt darstellt: Ein der Höhe nach unveränderbarer Fehlergleichstrom wird sprungartig eingeschaltet und die Zeit nach dem Einschaltvorgang gemessen, die der Fehlerstromschutzschalter zur Auslösung benötigt. Durch diese Methode läßt sich jedoch lediglich die Auslösezeit, nicht aber der Auslösestrom des Fehlerstromschutzschalters bestimmen. Außerdem wird durch das sprungartige Einschalten des Gleichstroms der Fehlerstromschutzschalter mit einem derart breitbandigen Frequenzspektrum mit nicht unerheblichen Wechselstromamplituden beaufschlagt, so daß bei allstromsensitiven Fehlerstromschutzschaltern, das heißt bei Schutzschaltern mit einer Gleichstrom- und einer Wechselstromauslösekomponente, ein Ansprechen der Wechselstromkomponente erfolgt und dadurch eine Überprüfung der Gleichstromkomponentc überhaupt nicht möglich ist. In jedem Fall wird durch den Einschaltsprung das Auslöseverhalten des getesteten Fehlerstromschutzschalters beeinflußt.

Als weiterer Stand der Technik ist es an wechselstromsensitiven Fehlerstromschutzschaltern bereits bekannt geworden, mit ansteigendem Wechselstrom den Auslösestrom zu ermitteln. Dieses Verfahren wird in einigen Prüfgeräten seit Jahren verwendet, um derartige Fehlerstromschutzschalter zu überprüfen. Als druckschriftliche Veröffentlichungen sind beispielsweise DE 38 35 677 und EP 368 030 zu nennen.

### Aufgabenstellung, Lösung:

Der Erfindung liegt die Aufgabe zugrunde, ein Verfahren anzugeben, mit dem elektronische gleichstromsensitive Schutzschalter oder kombinierte allstromsensitive Schutzschalter, d.h. Schutzschalter mit einer herkömmlichen Wechselstromauslöseeinheit (Magnetauslöseeinheit - Summenstromwandler), die mit einer elektronischen Auslöseeinheit kombiniert ist, unkompliziert überprüfen zu können. Diese Aufgabe wird durch die Merkmalskombination des Anspruches 1 gelöst, vorteilhafte Weiterbildungen des Verfahrens ergeben sich aus den Ansprüchen 2 - 11, eine vorteilhafte Vorrichtung zur Durchführung des Verfahrens ergibt sich aus den Ansprüchen 12 - 15.

Die Erfindung geht von der Erkenntnis aus, daß es bei gleichstrom- oder allstromsensitiven Schutzschaltern nicht möglich ist, einen Gleichstrom als Impuls sprungartig hochzufahren, da ein derartiges sprunghaftes Verhalten eines Stromverlaufes ein großes Spektrum an Oberwellen im Bereich der ansteigenden und abfallenden Flanken des Impulses aufweist. Die Wechselstromkomponente des Schutzschalters würde aufgrund des auftretenden Spektrums ansprechen. Der elektronische Schutzschalteranteil wird aber entweder gar nicht reagieren oder es kann nicht mit Sicherheit ausgesagt werden, ob die Auslöseelektronik für den Gleichstromanteil wirklich angesprochen hat. Es ist auch nicht ohne weiteres möglich, einen Gleichstrom - bezogen auf L-PE - einzuspeisen, da dieser entgegen der treibenden Netzspannung aufrechterhalten werden müßte. Über einen längeren Zeitraum können die dabei auftretenden hohen Leistungen nicht ohne weiteres beherrscht werden, so daß derartige Verfahren nicht sinnvoll anwendbar sind.

Als Kern der Erfindung wird es angesehen, eine durch eine Ablaufsteuerung steuerbare Gleichstromquelle vorzusehen und diese an den neutralen Leiter N und den Schutzleiter PE einer elektrischen Anlage anzuschließen, in der sich der zu prüfende Fehlerstromschutzschalter befindet. Dadurch kann der Prüfstrom bei relativ geringer Spannung mit geringer Leistung eingespeist werden. Im N-PE-Kreis ist ferner ein Strommeßgerät vorgesehen, das die im Meßkreis herrschenden Prüfströme erfassen kann. Der aus der steuerbaren Gleichstromquelle bezogene Prüfstrom wird erhöht und durch das Strommeßgerät in dem Moment gemessen und festgehalten, in dem die gleichstromsensitive elektronische Komponente des angeschlossenen Fehlerstromschutzschalters anspricht. Dabei wird - falls es sich bei dem angeschlossenen Fehlerstromschutzschalter um einen allstromsensitiven Fehlerstromschutzschalter handelt - ein Ansprechen des wechselstromsensitiven Auslösekreises sicher vermieden.

Die Erfindung nutzt mit Vorteil aus, daß der N-Leiter und der PE-Leiter im wesentlichen auf dem gleichen Potential liegen und deswegen nur vergleichsweise geringe Leistungen eingespeist werden müssen, um den Schutzschalter zum Auslösen zu bringen. Dies ist mit relativ geringem apparativem Aufwand machbar, die angelegte Spannung beträgt maximal 12 Volt, so daß abhängig von Kreis- und Meßwiderstand die Ströme auch entsprechend klein sind. Es wird maximal 1 Ampere Auslösestrom eingespeist, eine entsprechende Stromquelle kann in einem relativ kleinen Gerät vorgesehen und mit einer Ablaufsteuerung kombiniert werden.

Es ist vorteilhaft, die Erhöhung des Prüfstromes während eines Prüfdurchlaufes gesteuert durch die Ablaufsteuerung mit mindestens zwei unterschiedlichen Gradienten durchzuführen. Dies hat seinen Grund darin, daß für den unteren Bereich zwei Schutzschaltertypen bekannt sind, die bei 10 mA und 30 mA auslösen sollen. Andere, höher dimensionierte DC-FI-Schutzschalter lösen bei höheren Strömen, insbesondere 100, 300 und 500 mA aus. Um einen Meßvorgang nun nicht unnötig in die Länge zu ziehen und dennoch bzgl. des Auslösestroms eine hinreichend feine Meßauflösung zu erzielen, ist es zweckdienlich, im unteren Bereich zunächst den Meßstrom langsam ansteigen zu lassen und im oberen Bereich dann schneller.

Vorteilhafterweise bezieht die Gleichstromquelle die zum Treiben des Prüfstroms notwendige Leistung aus dem speisenden Netz über den Phasenanschluß und den Neutralanschluß. Über einen Wandler wird die erforderliche Leistung in die Strecke N-PE des Netzes eingespeist, in der sich der zu prüfende Fehlerstromschutzschalter befindet.

Um Meßfehler zu vermeiden und das Verfahren weiter zu vereinfachen, ist vorgesehen, daß vor dem Start des Prüfdurchlaufes, das heißt vor der Prüfstromerhöhung, der korrekte Anschluß der Gleichstromquelle an dem L-, N- und PE-Leiter automatisch überprüft und bei fehlerhaftem Anschluß der Start des Prüfdurchlaufes automatisch abgeschaltet wird. Gleichzeitig wird bei fehlerhaftem Anschluß ein Fehlermeldungssignal abgegeben. Eine Unterbrechung des Prüfdurchlaufes kann dann erfolgen, wenn während eines Prüfdurchlaufes festgestellt wird, daß die an den Anschlüssen N und PE anliegende Spannung die Deckenspannung der Gleichstromquelle übersteigt, so daß die Gleichstromquelle den notwendigen Auslösestrom nicht mehr liefern kann.

Die Erfindung ist anhand eines vorteilhaften Ausführungsbeispiels in der Zeichnungsfigur näher erläutert. Diese zeigt ein Blockschaltbild der wesentlichen Komponenten eines Prüfgerätes zur Prüfung von allstrom- und gleichstromsensitiven Fehlerstromschutzschaltern.

Das in der Zeichnungsfigur angedeutete Prüfgerät 1 umfaßt eine Gleichstromquelle 2, deren Ausgänge 3, 3' mit dem neutralen Leiter N und dem Schutzleiter PE einer elektrischen Anlage 4 zur Einspeisung eines Prüfstromes verbindbar ist. Außerdem ist eine elektrische Ablaufsteuerung 5 vorgesehen, deren Ausgangssignal 6 zur Steuerung der Gleichstromquelle 2 zuführbar ist. Innerhalb des Kreises N-PE ist ferner eine Strommeßvorrichtung 7 vorgesehen, deren Ausgangssignal 8 einer Speichereinrichtung 9 der Ablaufsteuerung 5 zuführbar ist und im Augenblick des Ansprechens eines DC-FI-Schutzschalters 10 den fließenden Meßstrom zu erfassen. Ferner ist eine Anzeigevorrichtung 11 vorhanden, über die der erfaßte und gespeicherte Meßstromwert dem Benutzer angezeigt werden kann. Alternativ oder zusätzlich ist es natürlich möglich, einen Meßprotokolldrucker an das Gerät anzuschließen.

Die Eingänge der Stromquelle 2 sind mittels Anschlußelementen an den Phasen (L) und den Neutralanschluß N des zu vermessenden Netzes 4 angeschlossen. Mit 12 ist ein Startschalter vorgesehen, mit dem die Ablaufsteuerung 5 manuell gestartet werden kann.

An eine Fehlerlogikschaltung 13, die Bestandteil der Ablaufsteuerung ist oder zumindest mit dieser zusammenwirkt, ist eine Mehrzahl von Abbruchanzeigeelementen 14 angeschlossen, über die eine fehlerverursachende Verpolung der Anschlüsse und/oder Übertemperatur des Prüfgerätes 1 und/oder ein zu großer Widerstand des zu vermessendes Netzes 4 angezeigt werden kann.

### BEZUGSZEICHENLISTE

- 1: Prüfgerät
- 2: Gleichstromquelle
- 3, 3': Ausgänge
- 4: elektrische Anlage
- 5: Ablaufsteuerung
- 6: Ausgangssignal
- 7: Strommeßvorrichtung
- 8: Ausgangssignal
- 9: Speichereinrichtung
- 10: Schutzschalter
- 11: Anzeigevorrichtung
- 12: Startschalter
- 13: Fehler-Logik-Schaltung

- N: neutraler Leiter
- PE: Schutzleiter

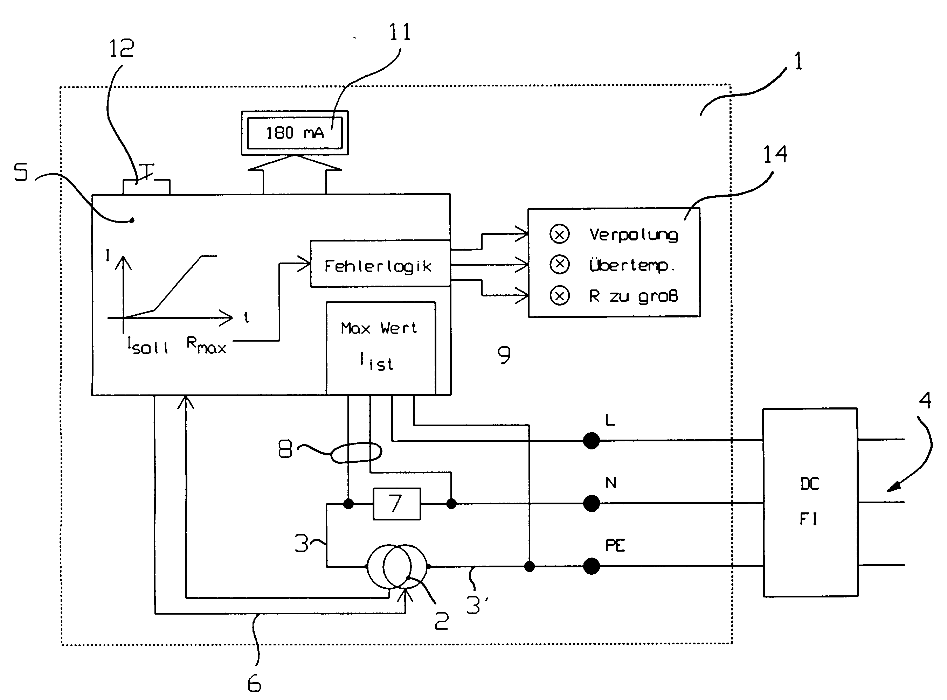

## Patentansprüche

1. Verfahren zur Funktionsprüfung und Ermittlung des Auslösestroms von gleichstrom- oder allstromsensitiven Fehlerstromschutzschaltern mit folgenden Verfahrensschritten:
a) Vorsehen einer durch eine Ablaufsteuerung (5) steuerbaren Gleichstromquelle (2);
b) Verbinden dieser Gleichstromquelle mit dem neutralen Leiter (N) und dem Schutzleiter (PE) einer elektrischen Anlage (4), in der sich der zu prüfende Fehlerstromschutzschalter (F1) befindet, und Einspeisung eines Prüfstromes;
c) Vorsehen einer Strommeßvorrichtung (7) im N-PE-Kreis und Erfassung des im Meßkreis herrschenden Prüfstromes;
d) Erhöhung des aus der steuerbaren Gleichstromquelle bezogenen, in den N-PE-Kreis eingespeisten Prüfstromes durch die Ablaufsteuerung;
e) automatische Erfassung und Anzeige des durch das Strommeßelement erfaß-ten Prüfstroms im Moment des Ansprechens der gleichstromsensitiven Komponente des angeschlossenen Fehlerstromschutzschalters, wobei
f) bei allstromsensitiven Fehlerstromschutzschaltern ein Ansprechen des wechselstromsensitiven Auslösekreises vermieden wird.

2. Verfahren nach Anspruch 1,
**dadurch gekennzeichnet, daß**
die Erhöhung des Prüfstromes während eines Prüfdurchlaufes gesteuert durch die Ablaufsteuerung mit mindestens zwei unterschiedlichen Gradienten erfolgt.

3. Verfahren nach Anspruch 2,
**dadurch gekennzeichnet, daß**
der Gradient mit zunehmenden Strom stufig oder linear ansteigt.

4. Verfahren nach einem der vorhergehenden Ansprüche,
**dadurch gekennzeichnet, daß**
die Gleichstromquelle die zum Treiben des Prüfstroms notwendige Leistung aus dem speisenden Netz über den Phasen-(L) und den Neutral-(N)- Anschluß bzw. die jeweils aktiven Leiter des Netzes entnimmt und über einen Wandler in die Strecke N-PE des Netzes einspeist, in der sich der zu prüfende Fehlerstromschutzschalter befindet.

5. Verfahren nach einem der vorhergehenden Ansprüche,
**dadurch gekennzeichnet, daß**
die Prüfspannung, die infolge des Prüfstroms zwischen dem Schutzleiteranschluß und einer neutralen Schutzerde während des Prüfdurchlaufs anliegt, kleiner als 12 V ist.

6. Verfahren nach einem der vorhergehenden Ansprüche,
**dadurch gekennzeichnet, daß**
vor dem Start des Prüfdurchlaufs der korrekte Anschluß der Gleichstromquelle an den L-, N- und PE-Leiter automatisch überprüft und bei fehlerhaftem Anschluß (z.B. L und N vertauscht oder PE nicht angeschlossen) der Start des Prüfdurchlaufs automatisch blockiert wird.

7. Verfahren nach Anspruch 6,
**dadurch gekennzeichnet, daß**
bei fehlerhaftem Anschluß ein Fehlermeldungssignal abgegeben wird.

8. Verfahren nach einem der vorhergehenden Ansprüche,
**dadurch gekennzeichnet, daß**
während eines Prüfdurchlaufs die an den Anschlüssen N und PE anliegende Spannung gemessen und überprüft wird und bei Überschreiten der Deckenspannung der Gleichstromquelle der Prüfdurchlauf abgebrochen und eine Fehlermeldung (R zu groß) angezeigt wird.

9. Verfahren nach einem der vorhergehenden Ansprüche,
**dadurch gekennzeichnet, daß**
der Prüfstrom bis etwa 1 A gesteigert wird.

10. Verfahren nach Anspruch 3,
**dadurch gekennzeichnet, daß**
das Verhältnis der Steigungen des Prüfstroms in einem unteren Bereich (unterhalb etwa 60mA ... 100mA) zu einem oberen Bereich (oberhalb etwa 60mA ... 100mA) etwa 1 : 10 beträgt.

11. Verfahren nach einem der vorhergehenden Ansprüche,
**dadurch gekennzeichnet, daß**
das Gradient des Auslösestroms kleiner als 0,33 A/sec ist.

12. Prüfgerät zur Funktionsprüfung und Ermittlung des Auslösestromes von gleichstrom- oder allstromsensitiven Fehlerstromschutzschaltern einer elektrischen Anlage, mit einem Gerät, das an die Anlage zur Messung angeschlossen wird,
**dadurch gekennzeichnet, daß**
in dem Prüfgerät (1) enthalten sind:
a) eine Gleichstromquelle (2), deren Ausgänge (3, 3') in Meßbetriebsverschaltung des Prüfgerätes (1) mit dem neutralen Leiter N und dem Schutzleiter PE der elektrischen Anlage (4) zur Einspeisung eines Prüfstroms elektrisch verbunden sind;
b) eine elektrische Ablaufsteuerung (5), deren Ausgangssignal (6) der Gleichstromquelle (2) zur Prüfstromerhöhung zuführbar ist;
c) eine Strommeßvorrichtung (7), in der der Meßstrom innerhalb des Kreises N-PE erfaßbar ist und deren Ausgangssignal (8) einer Speichereinrichtung (9) der Ablaufsteuerung (5) zuführbar ist, um im Augenblick des Ansprechens des Schutzschalters (10) den fließenden Meßstrom zu erfassen;
d) eine Anzeigevorrichtung (11), über die der erfaßte und gespeicherte Meßstromwert anzeigbar und gegebenenfalls über eine Ausgabeeinrichtung protokollierbar ist,
e) eine Mehrzahl von Abbruchanzeigeelementen (14), die mit einer Fehlerlogikschaltung (13) der Ablaufsteuerung (5) verbunden sind und über die eine Fehlerverursachung der Verpolung und/oder Übertemperatur des Prüfgerätes und/oder ein zu großer Widerstand der zu vermessenden elektrischen Anlage anzeigbar ist.

13. Vorrichtung nach Anspruch 12,
**dadurch gekennzeichnet, daß**
die Eingänge der Stromquelle (2) mittels Anschlußelementen an den Phasen-(L) und den Neutral-(N)-Anschluß des zu vermessenden Netzes (4) anschließbar sind.

14. Vorrichtung nach Anspruch 12 oder 13,
**dadurch gekennzeichnet, daß**
ein Startschalter (12) zum manuellen Starten der Ablaufsteuerung (5) vorgesehen ist.

## Claims

1. Method for functionally testing and determining the tripping current of residual current circuit breakers sensitive to direct current or universal current, having the following method steps:
a) providing a direct-current source (2) which can be controlled by a sequence control system (5);
b) connecting this direct-current source to the neutral conductor (N) and the protective conductor (PE) of an electrical installation (4) in which the residual current circuit breaker (F1) to be tested is located, and feeding in a test current;
c) providing a current-measuring device (7) in the N-PE cicrcuit and detecting the test current prevailing in the measuring circuit;
d) using the sequence control system to increase the test current drawn from the controllable direct-current source and fed into the N-PE circuit; and
e) automatically detecting and displaying the test current, detected by the current-measuring element, at the instant of response of the direct-current sensitive component of the connected residual current circuit breaker,
f) a response of the direct-current sensitive trip circuit being avoided in the case of universal-current sensitive residual current circuit breakers.

2. Method according to Claim 1, characterized in that the increase in the test current during a test run is performed under the control of the sequence control system with at least two different gradients.

3. Method according to Claim 2, characterized in that the gradient rises with increasing current in steps or linearly.

4. Method according to one of the preceding claims, characterized in that the direct-current source extracts the power required to drive the test current from the supply system via the phase connection (L) and the netrual connection (N) or the respectively active conductor of the system, and feeds it via a converter into the N-PE section of the system in which the residual current circuit breaker to be tested is located.

5. Method according to one of the preceding claims, characterized in that the test voltage which is present during the test run between the protective-conductor terminal and a neutral protective earth as a consequence of the test current is smaller than 12 V.

6. Method according to one of the preceding claims, characterized in that the correct terminal of the direct-current source is automatically checked before the start of the test run at the L conductor, N conductor and PE conductor, and the start of the test run is automatically blocked in the event of a faulty terminal (for example L and N interchanged or PE not connected).

7. Method according to Claim 6, characterized in that a fault signal is output in the event of a faulty terminal.

8. Method according to one of the preceding claims, characterized in that the voltage present at the terminals N and PE is measured and checked during a test run, and the test run is broken off upon overshooting of the ceiling voltage of the direct-current source and a fault message (R too large) is displayed.

9. Method according to one of the preceding claims, characterized in that the test current is raised to about 1 A.

10. Method according to Claim 3, characterized in that the ratio of the gradient of the test current in a lower region (below about 60 mA....100 mA) to that in an upper region (above about 60 mA..... 100 mA) is about 1:10.

11. Method according to one of the preceding claims, characterized in that the gradient of the tripping current is smaller than 0.33 A/sec.

12. Test set for functionally testing and determining the tripping current of residual current circuit breakers, sensitive to direct current or universal current, of an electrical installation, having a unit which is connected to the installation for the purpose of measurement, characterized in that contained in the test set (1) are:
a) a direct-current source (2) whose outputs (3, 3') are electrically connected in a measurement operation circuit of the test set (1) to the neutral conductor (N) and the protective conductor (PE) of the electrical installation (4) for the purpose of feeding in a test current;
b) an electrical sequence control system (5) whose output signal (6) can be fed into the direct-current source (2) for the purpose of increasing the test current;
c) a current-measuring device (7) in which the measuring current can be detected within the N-PE circuit and whose output signal (8) can be fed to a storage device (9) of the sequence control system (5) in order to detect the measuring current flowing at the instant of the response of the circuit breaker (10),
d) a display device (11) via which the detected and stored measured-current value can be displayed and, if appropriate, printed out via an output device; and
e) a plurality of discontinuation display elements (14) which are connected to a residual logic circuit (13) of the sequence control system (5) and via which it is possible to display fault causation of the polarity reversal and/or excess temperature of the test set and/or to display an excessively high resistance of the electrical installation to be meausured.

13. Device according to Claim 12, characterized in that the inputs of the current source (2) can be connected to the phase terminal (L) and the neutral terminal (N) of the system (4) to be measured by means of connecting elements.

14. Device according to Claim 12 or 13, characterized in that a start switch (12) is provided for manually starting the sequence control system (5).

## Revendications

1. Procédé de vérification du fonctionnement et de détermination du courant de déclenchement de disjoncteurs à courant de défaut sensibles au courant continu ou tous courants, comportant les étapes opératoires suivantes :
a) prévision d'une source de courant continu (2) pouvant être commandée par une commande séquentielle (5) ;
b) connexion de cette source de courant continu au conducteur neutre (N) et au conducteur de protection (PE) d'une installation électrique (4) dans laquelle se trouve le disjoncteur à courant de défaut à tester (F1), et chargement d'un courant d'essai ;
c) prévision d'un dispositif de mesure du courant (7) dans le circuit N-PE et enregistrement du courant d'essai présent dans le circuit de mesure ;
d) élévation par la commande séquentielle du courant d'essai alimentant le circuit N-PE relatif à la source de courant continu commandable ;
e) enregistrement et affichage automatiques du courant d'essai enregistré par l'élément de mesure du courant au moment de l'activation des composants sensibles au courant continu du disjoncteur à courant de défaut connecté, ce qui,
f) dans le cas de disjoncteurs à courant de défaut sensibles à tous courants, empêche l'activation du circuit de déclenchement sensible au courant alternatif.

2. Procédé selon la revendication 1, caractérisé en ce que l'élévation du courant d'essai au cours d'une procédure d'essai commandée par la commande séquentielle s'opère avec au moins deux gradients différents.

3. Procédé selon la revendication 2, caractérisé en ce que le gradient augmente proportionnellement à l'augmentation du courant de façon graduelle ou linéaire.

4. Procédé selon l'une quelconque des revendications précédentes, caractérisé en ce que la source de courant continu prélève à partir du réseau d'alimentation la tension nécessaire pour déclencher le courant d'essai via le raccordement aux phases (L) et le raccordement neutre (N) ou, selon les cas, les conducteurs du réseau respectivement actifs, et en ce qu'elle alimente via un transformateur la section N-PE du réseau dans laquelle se trouve le disjoncteur à courant de défaut à tester.

5. Procédé selon l'une quelconque des revendications précédentes, caractérisé en ce que la tension d'essai présente au cours de la procédure d'essai, du fait du courant d'essai entre le raccord au conducteur de protection et une terre de protection neutre, est inférieure à 12 V.

6. Procédé selon l'une quelconque des revendications précédentes, caractérisé en ce que, avant le début de la procédure d'essai, il est automatiquement contrôlé la connexion correcte de la source de courant continu aux conducteurs L, N et PE et qu'en cas de connexion défectueuse (par ex. inversion entre L et N, ou PE non raccordé), le début de la procédure d'essai est automatiquement bloqué.

7. Procédé selon la revendication 6, caractérisé en ce qu'un signal d'erreur est délivré en cas de connexion défectueuse.

8. Procédé selon l'une quelconque des revendications précédentes, caractérisé en ce qu'au cours d'une procédure d'essai, la tension présente aux raccords N et PE est mesurée et contrôlée, et qu'en cas de dépassement de la tension de plafond de la source de courant continu, la procédure d'essai est interrompue et une indication d'erreur est affichée (R trop élevée).

9. Procédé selon l'une quelconque des revendications précédentes, caractérisé en ce que le courant d'essai est poussé jusqu'à environ 1 A.

10. Procédé selon la revendication 3, caractérisé en ce que le rapport des augmentations du courant d'essai entre plage inférieure (en deçà d'environ 60 mA à 100 mA) et plage supérieure (au-delà d'environ 60 mA à 100 mA) est de l'ordre de 1:10.

11. Procédé selon l'une quelconque des revendications précédentes, caractérisé en ce que le gradient du courant de déclenchement est inférieur à 0,33 A/seconde.

12. Appareil d'essai pour la vérification du fonctionnement et la détermination du courant de déclenchement de disjoncteurs à courant de défaut d'une installation électrique, sensibles au courant continu ou tous courants, avec un appareil qui est connecté à l'installation pour la mesure, caractérisé en ce que sont contenus dans l'appareil d'essai (1) :
a) une source de courant continu (2), dont les sorties (3, 3'), en situation de câblage en fonctionnement de mesure de l'appareil d'essai (1), sont reliées électriquement au conducteur neutre N et au conducteur de protection PE de l'installation électrique (4) pour le chargement d'un courant d'essai ;
b) une commande électrique séquentielle (5), dont le signal de sortie (6) peut être amené à la source de courant continu (2) pour augmenter le courant d'essai ;
c) un dispositif de mesure du courant (7), dans lequel le courant de mesure peut être déterminé à l'intérieur du circuit N-PE et dont le signal de sortie (8) peut être amené à un dispositif de mémoire (9) de la commande séquentielle (5), pour enregistrer le courant de mesure qui s'écoule au moment de l'activation du disjoncteur (10) ;
d) un dispositif d'affichage (11) via lequel la valeur du courant de mesure détectée et mémorisée peut être affichée et éventuellement protocolable via un périphérique de sortie ;
e) une pluralité d'éléments indicateurs d'interruption (14) qui sont reliés à un câblage logique de détection d'erreurs (13) de la commande séquentielle (5) et qui permettent de démontrer une cause d'erreur de polarisation et/ou une surchauffe de l'appareil de mesure et/ou une résistance trop élevée de l'installation électrique à contrôler.

13. Dispositif selon la revendication 12, caractérisé en ce que les entrées de la source de courant continu (2) peuvent être connectées aux raccordements phases (L) et neutre (N) du réseau à mesurer (4) au moyen d'éléments de connexion.

14. Dispositif selon la revendication 12 ou 13, caractérisé en ce qu'un commutateur de démarrage (12) est prévu pour le démarrage manuel de la commande séquentielle (5).
